# EUROPEAN PATENT SPECIFICATION

(11) **EP 0 483 979 B1**
(45) Date of publication and mention of the grant of the patent: **27.12.1995**
(21) Application number: 91309053.6
(22) Date of filing: 02.10.1991
(51) Int. Cl.: H05K 3/46, H05K 3/42

(54) **Method for producing printed circuit boards**
Verfahren zur Herstellung einer Leiterplatte
Méthode de production d'un panneau à circuit imprimé

(30) Priority: 30.10.1990 FI 905366
(43) Date of publication of application: 06.05.1992
(73) Proprietor: NOKIA MOBILE PHONES LTD., 24101 Salo (FI)
(72) Inventor: Pienimaa, Seppo, SF-24280 Salo (FI)
(74) Representative: Barlow, Roy James

(56) References cited:
- EP-A- 0 189 975
- US-A- 3 568 312
- US-A- 4 211 603
- US-A- 4 737 446

## Description

The present invention relates to a method for producing printed circuit boards, in particular multilayer circuit boards, using an additive method.

The printed circuit board structure according to the invention is based on both subtractive and additive fabrication methods. In a subtractive method, the desired conductor pattern is etched on the copper cladding of the base material. In an additive method the conductor pattern is deposited on a dielectric base material. Attainment of reliable adhesion has been a problem in the additive methods, as has been the substandard thermal stability of acrylate-butadiene insulating materials used in the method. Newer compositions of photoimageable polymer materials of higher stability which are under development facilitate the production of printed-circuit boards of higher quality and precision using additive methods. These advances in additive PCB techniques can also be employed in the production of high-precision multilayer boards. The cost-efficiency of this production technology surpasses by a wide margin the conventional lamination method for producing multilayer circuit boards.

With the decreasing size of drilled holes, increasing demands on the conductor density of PCBs raises drilling costs significantly. Fabrication of buried interconnections using conventional production techniques of multilayer boards also requires drilling prior to lamination. By contrast, photoimageable polymer intermediate insulation makes it possible to fabricate the holes of buried inter-layer vias while at the same time photoimaging the polymer insulating layers. Along with the increase in packaging density, the base materials become thinner, which facilitates the fabrication of vias by punching. Compared with drilling, punching is an appreciably cheaper production method.

In multilayer circuit boards the interconnections between laminated layers are made by metallization of the drilled holes. To produce a reliable contact, the drilled hole must have a smooth bore surface and the bore surface profile in the copper foil lining the drilled hole must also be smooth.

The method according to the invention uses a photoimageable insulating layer which replaces laminated insulating layers.

The fabrication of interconnection holes in the polymer insulating layer that lies between an underlying conductor pattern and the conductor pattern to be additively deposited atop it takes place at the same time as the polymer insulating layer is exposed during image transfer. When etching the punched base laminate, the copper laminate which is possibly delaminated about a hole will also be etched, thus making it impossible to achieve a reliable contact to the vertically sheared cross section of the via's collar. This problem is avoided if the insulating layer around the vias is removed sufficiently widely to allow the plated-through metallization to establish contact also with the via's collar. In the production method according to the invention, all additively deposited metallizations of conductor patterns are made in a single process.

The method according to the invention which is an invention of genuine combination is defined in claim 1.

Claim 1 is delimited over EP-A-0189975 which discloses a PCB with contact between claddings on opposed surfaces, along through-holes.

The invention may provide the benefits described below as compared to conventional production techniques:
- by virtue of using direct punching of the base material for all holes, damage caused by making holes on etched conductor patterns which results in decreased yield is avoided, as is the access of debris from the hole-making process to the clean room spaces of the production line;
- by virtue of assuring good electrical contact between the metallizations of the vias and the collars surrounding the holes, the process of producing holes in the base material and the deposition of metallization about the rims of the holes become noncritical;
- metallizations of the interconnection holes are subjected to smaller stresses from the differences of thermal expansion coefficients, since the thermal expansion coefficient of the base material is smaller than that of the insulating layers;
- contacts established via the holes in the insulating layer between the copper cladding of the base material and the deposited metallization contribute to increased conductor density;
- restrictions imposed on layout design by the use of electrolytic deposition are avoided, because the interconnections and the deposited conductor pattern are produced by chemical processing at the same time; and
- the contact areas serving for the mounting of components can be chemically plated with solder, or alternatively, protected with, e.g., an imidazole protective layer.

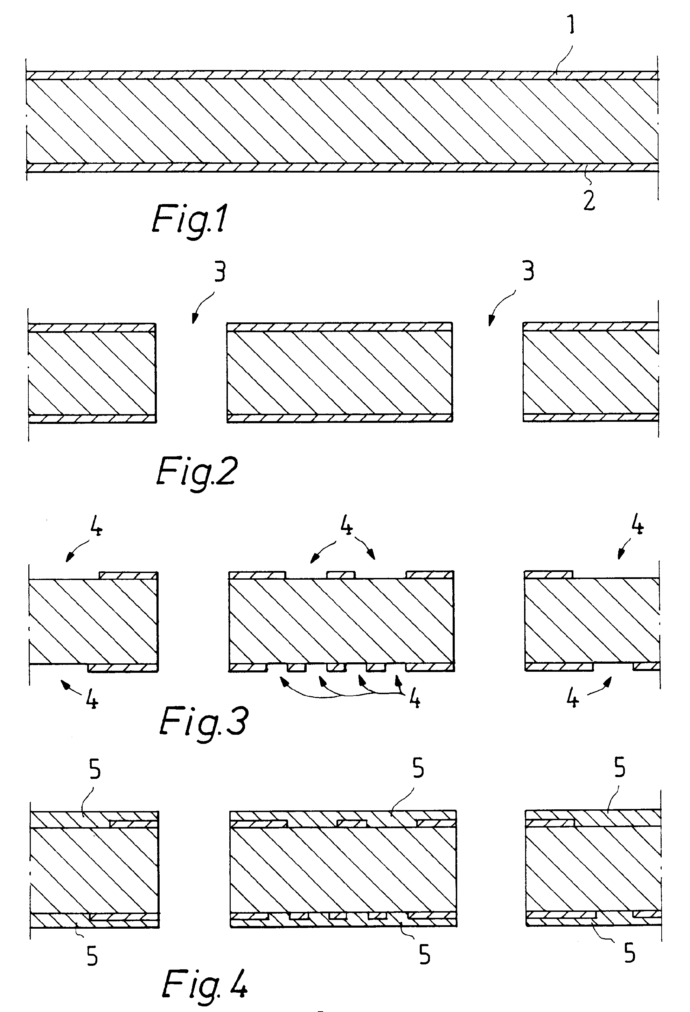

In the following the invention is described by way of an exemplifying embodiment with reference to the attached drawings in which Figs. 1 to .9 illustrate the fabrication stages of a PCB from the base material to a finished product.

Fig. 1 shows the base material with its copper claddings 1, 2.

Fig. 2 shows the base material with holes 3 which are produced by punching. Mechanical and chemical methods are used for the cleaning and deburring the copper cladding 1, 2.

Fig. 3 shows the PCB after the image transfer and etching stages, whereby the copper cladding at areas 4 is removed.

Fig. 4 shows the photoimageable polymer insulating layer 5 applied onto the surfaces of the PCB.

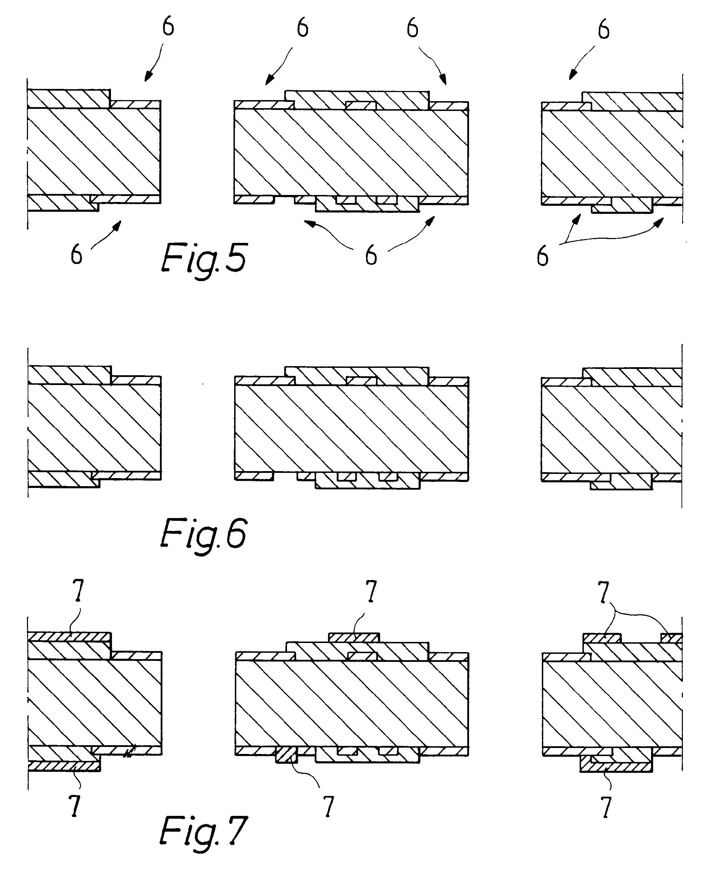

Fig. 5 shows the PCB after exposure and development, whereby holes 6 are produced to the insulating layer 5.

Fig. 6 shows the PCB after the adhesion improvement and activation treatments of its surfaces.

Fig. 7 shows the PCB after image transfer in which a photoimageable and developable insulating layer is used so that layers 7 are produced.

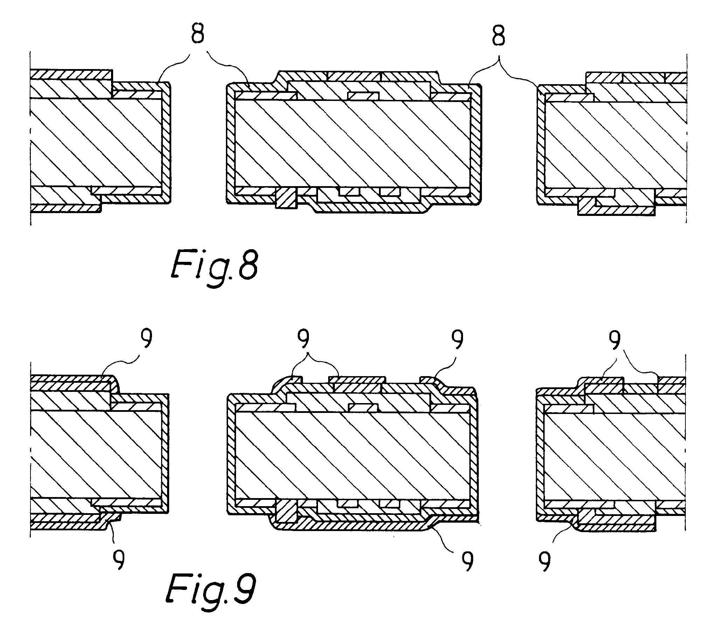

Fig. 8 shows the PCB after the chemical deposition of the metallization 8 with which the desired conductor patterns, contact areas and interconnections are produced onto the activated areas not protected with the photoimaged insulating layer.

Fig. 9 finally shows the PCB with a solder mask 9 applied to it that protects the conductor pattern at other areas except those intended for establishing contacts.

## Claims

1. A method for producing printed circuit boards comprising the steps of :-
(a) providing a substrate for a printed circuit board, said substrate having copper claddings (1, 2) respectively on its opposed faces;
(b) punching holes (3) through the substrate and claddings;
(c) cleaning the copper claddings mechanically and optionally said mechanical cleaning is accompanied by chemical cleaning;
(d) using image transfer and etching (4) techniques to produce patterns in the cladding layers which expose surface portions of the substrate; and
(e) a first photoimageable polymer insulating layer (5) is applied to the exposed surface of the printed circuit board substrate and to the pattern of cladding remaining after the etching;
(f) the printed circuit board is subjected to exposure and development of said first polymer insulating layer (5) to expose collars of the cladding, surrounding through connection holes (3) and vias to produce patterns elsewhere in the cladding layer;
(g) the opposite faces of the printed circuit board are subjected to adhesion improvement and activation treatment necessary for chemical deposition of metal on said thus treated faces;
(h) a second photoimageable and developable insulating layer (7) is applied on the faces of the printed circuit board; and
(i) image transfer and development of said second insulating layer (7) is performed in order to provide a pattern of said second insulating layer to protect areas of the already partially formed printed circuit board from the subsequent application of the metallization (8);
(j) applying said metallization (8) by chemical deposition to cover the walls of the holes and areas not protected by said pattern of said second insulating layer;
wherein after the chemical deposition of the metallization (8) a solder mask (9) is applied to the printed circuit board to protect areas which are not intended for establishing contacts.

## Patentansprüche

1. Verfahren zur Herstellung von gedruckten Leiterplatten, mit folgenden Schritten:
(a) Bereitstellen eines für eine Leiterplatte vorgesehenen Substrats mit Kupferkaschierungen (1, 2) jeweils auf der Oberseite und der Unterseite;
(b) Stanzen von Löchern (3) durch das Substrat und die Kaschierungen hindurch;
(c) mechanisches und optional zusätzlich chemisches Reinigen der Kupferkaschierungen;
(d) Anwenden von Bildübertragungs- und Ätztechniken (4). um in den Kaschierungsschichten Bereiche der Oberfläche des Substrats freilegende Strukturen zu erzeugen;
(e) Aufbringen einer ersten photobildfähigen Polymerisolierschicht (5) auf die freigelegte Oberfläche der Leiterplatte und die nach dem Ätzen überbleibenden Strukturen der Kaschierung;
(f) Belichtung und Entwicklung der ersten Polymerisolierschicht (5) der Leiterplatte zum Freilegen von Kaschierungsmanschetten um Verbindungslöcher (3) und Durchgänge herum und zur Erzeugung weiterer Strukturen in der Kaschierungsschicht:
(g) Adhesionsverbesserung und Aktivierungsbehandlung der Ober- und Unterseite der Leiterplatte, da dieses für eine chemische Ablagerung von Metall auf den so behandelten Seiten notwendig ist:
(h) Aufbringen einer zweiten photobildfähigen und entwicklungsfähigen Isolierschicht (7) auf die Seiten der Leiterplatte:
(i) Durchführen von Bildübertragung und Entwicklung der zweiten Isolierschicht (7), um Bereiche der schon teilweise gestalteten Leiterplatte vor der folgenden Aufbringung einer Metallisierung (8) schützende Strukturen der zweiten Isolierschicht bereitzustellen; und
(j) Aufbringen der Metallisierung (8) durch chemische Ablagerung zur Bedeckung der Wände der Löcher und der nicht von der Struktur der zweiten Isolierschicht geschützten Bereiche, wobei zum Schutz nicht zur Kontaktierung vorgesehener Bereiche nach der chemischen Ablagerung der Metallisierung (8) eine Lötmaske (9) auf die Leiterplatte aufgebracht wird.

## Revendications

1. Procédé pour produire des cartes de circuits imprimés comprenant les étapes consistant à :
a) prévoir un substrat pour une carte de circuits imprimés, ledit substrat comportant des couches de placage de cuivre (1, 2) respectivement, sur ses faces opposées ;
b) perforer des trous (3) à travers le substrat et les couches de placage ;
c) nettoyer mécaniquement les couches de placage en cuivre et optionnellement ledit nettoyage mécanique est accompagné par un nettoyage chimique ;
d) utiliser une technique de transfert d'images et de gravure (4) pour produire des motifs dans les couches de placage qui exposent des parties de surface du substrat ; et
e) une première couche isolante de polymère photoimageable (5) est appliquée à la surface exposée du substrat de la carte de circuits imprimés et au motif de la couche de placage restant après la gravure ;
f) la carte de circuits imprimés est soumise à exposition et au développement de ladite première couche isolante de polymère (5) afin d'exposer les pourtours de la couche de placage, entourant les trous de connexion (3) et les trous de traversée afin de produire des motifs n'importe où dans la couche de placage ;
g) les faces opposées de la carte de circuits imprimés sont soumises à une augmentation de l'adhérence et un traitement d'activation est nécessaire pour dépôt chimique du métal sur les faces ainsi traitées ;
h) une seconde couche isolante photo-imageable et développable (7) est appliquée sur les faces de la carte de circuits imprimés ; et
i) le transfert d'image et le développement d'images de ladite seconde couche isolante (7) est effectué afin de procurer un motif de ladite seconde couche isolante afin de protéger les zones de la carte de circuits imprimés déjà partiellement formée de l'application ultérieure de la métallisation (8) ;
j) appliquer ladite métallisation (8) par dépôt chimique pour recouvrir les parois des trous et les zones non protégées par ledit motif de ladite seconde couche isolante ;
dans lequel après le dépôt chimique de la métallisation (8) un masque de soudure (8) est appliqué à la carte de circuits imprimés afin de protéger les zones qui ne sont pas destinées à établir des contacts.
